# EUROPÄISCHE PATENTANMELDUNG

(11) **EP 0 790 326 A1**
(43) Veröffentlichungstag der Anmeldung: **20.08.1997**
(21) Anmeldenummer: 96119665.6
(22) Anmeldetag: 07.12.1996
(51) Int. Cl.: C23C 14/00, C23C 14/08

(54) **Verfahren zum Ablagern einer optisch transparenten und elektrisch leitenden Schicht auf einem Substrat aus durchscheinendem Werkstoff**

(30) Priorität: 17.02.1996 DE 19605932
(71) Anmelder: Leybold Systems GmbH, D-63450 Hanau am Main (DE)
(72) Erfinder: Szczyrbowski, Joachim, Dr., 63773 Goldbach (DE); Zmelty, Anton, 63768 Hösbach (DE)

(57) **Zusammenfassung**

Bei einem Verfahren zum Ablagern einer optisch transparenten und elektrisch leitenden Schicht (2), einer sogenannten low-e Schicht, auf einem Substrat (1) aus durchscheinendem Werkstoff mit Hilfe der Kathodenzerstäubung in einer Hochvakuumkammer (15,15a) wird Zink oder dotiertes Zink als Targetmaterial für zwei in einer Ebene angeordnete, mit Wechselstrom betriebene Sputterkathoden (5,5a) verwendet, die gleiche räumliche Abstände zum Substrat (1) aufweisen, wobei ein Einlaß (24) für zwei Prozeßgase, einem inerten Gas und einem Reaktivgas, vorgesehen ist, und wobei der Reaktivgasanteil und die elektrische Leistungsdichte so bemessen sind, daß ein Zerstäuben der beiden Targets (3,3a) im metallischen Mode oder im Bereich zwischen metallischem und oxydischem Mode bewirkt wird.

## Beschreibung

Die Erfindung betrifft ein Verfahren zum Ablagern einer optisch transparenten und elektrisch leitenden Schicht, einer sogenannten low-e Schicht, auf einem Substrat aus durchscheinendem Werkstoff mit Hilfe der Kathodenzerstäubung in einer Hochvakuumkammer unter Verwendung von Zink oder einer dotierten Zinklegierung als Targetmaterial.

Es ist eine Vorrichtung zum Beschichten eines Substrats mit einem elektrisch isolierenden Werkstoff bekannt (GB-A-1 172 106), bei der zwei Targetelektroden in einer evakuierbaren Beschichtungskammer angeordnet sind, wobei in die Beschichtungskammer ein Prozeßgas einbringbar ist und die Elektroden jeweils mit einer Sekundärwicklung eines Wechselstromtransformators mit Wechselstrom gespeist sind, wobei die Targetelektroden beide in der Beschichtungskammer nebeneinander liegend und im gleichen Abstand zum Substrat angeordnet sind.

Weiterhin ist eine Vorrichtung zum reaktiven Beschichten eines Substrats mit einem elektrisch isolierenden Werkstoff bekannt (EP 0 502 242 A2), bestehend aus einer Wechselstromquelle, die mit zwei in einer evakuierbaren Beschichtungskammer angeordneten Magnetronkathoden verbunden ist, deren Targets zerstäubt werden, wobei zur Erreichung eines stabilen Prozesses und festhaftender, isolierender Schichten zwei erdfreie Ausgänge der Wechselstromquelle mit je einer Kathode verbunden und beide Kathoden in der Beschichtungskammer nebeneinander liegend in einem Plasmaraum vorgesehen sind, die zum gegenüberliegenden Substrat jeweils den gleichen räumlichen Abstand aufweisen und jeweils ein eigene Verteilerleitung für das Prozeßgas besitzen, wobei die Aufteilung des Reaktivgasflusses auf beide Verteilerleitungen von einem Regler über ein Leitwertregelventil gesteuert ist.

Schließlich ist ein Verfahren zum Herstellen von Scheiben mit hohem Transmissionsverhalten im sichtbaren Spektralbereich und mit hohem Reflexionsverhalten für Wärmestrahlung durch Beschichtung von transparenten Substraten mit Hilfe von Kathodenzerstäubung bekannt (DE 42 11 363 A1), bestehend aus
- einer ersten Schicht aus ZnO mit einer Dicke von etwa 400 Å,
- einer zweiten Schicht aus Ag mit einer Dicke von etwa 90 Å,
- einer dritten Schicht, die als metallische oder suboxydische (unterstöchiometrische) Schicht aus einem der Metalle Ti oder NiCr mit einer Dicke von etwa 15 Å gebildet ist,
- einer vierten Schicht aus ZnO mit einer Dicke von etwa 320 Å und
- einer fünften Schicht aus TiO₂ mit einer Dicke von etwa 70 Å.

Diese bekannte low-e Schicht ist jedoch nicht für alle Zwecke verwendbar, da sie nicht nur vergleichsweise teuer in der Herstellung ist, sondern vor allem sich infolge ihrer Weichheit bzw. Empfindlichkeit nicht für alle Zwecke eignet. Die in diesem Schichtpaket vorgesehene Zinkoxyd-Schicht ist im übrigen als reine Schutzschicht im oxydischen Mode und in einem Gleichstrom-Sputterprozeß aufgebracht mit dem Nachteil einer besonders niedrigen Abscheidungsrate.

Der vorliegenden Erfindung liegt nun die Aufgabe zugrunde, ein Verfahren anzugeben, das es ermöglicht, eine sehr unempfindliche low-e Schicht auf eine Glasscheibe aufzubringen, die besonders preiswert herstellbar ist, wobei das Verfahren eine hohe Abscheidungsrate und einen störfreien Betrieb ermöglichen soll. Die Schicht soll eine besonders hohe Lichttransmission und eine hohe Reflexion im Bereich der Wärmestrahlung zwischen 3 µm und 50 µm aufweisen.

Diese Aufgabe wird erfindungsgemäß dadurch gelöst, daß metallisch dotiertes Zink als Targetmaterial für zwei in einer Ebene angeordnete, mit Wechselstrom betriebene Sputterkathoden mit gleichen räumlichen Abständen zum Substrat verwendet werden und ein Einlaß für Prozeßgas, vorzugsweise für Argon und Sauerstoff, vorgesehen ist, wobei der Prozeßgasanteil und die elektrische Leistungsdichte so eingestellt sind, daß ein Zerstäuben der beiden Targets im metallischen Mode oder im Bereich zwischen metallischem und oxydischem Mode erfolgt. Weitere Merkmale und Einzelheiten sind in den Unteransprüchen beschrieben und gekennzeichnet.

ZnO konnte bisher nur im oxydischen Mode gesputtert werden. Bei konstanter Leistung ist die Sputterrate einer Kathode im oxydischen Mode wesentlich niedriger (ca. 5-10 mal) als im metallischen Mode. Ein anderer Nachteil eines Sputterprozesses im rein oxydischen Mode ist eine mit der Zeit steigende Bedeckung der Kathodenoberfläche im Sputtergraben durch isolierende Schichten (Verpickelung), was zu Prozeßinstabilitäten, wie z.B. Arcing und Erniedrigung der Sputterrate, führt. Die Bedeckung des Sputtergrabens wird intensiver mit steigender Kathodenleistung, so daß eine Ratenerhöhung durch Erhöhung der Kathodenleistung praktisch unmöglich ist. Auf Grund dieser Nachteile ist die Herstellung von Oxyd-low-e Glas durch Sputtern im oxydischen Mode unwirtschaftlich und wird auch nicht praktiziert.

Die Erfindung läßt die verschiedensten Ausführungsmöglichkeiten zu; eine davon ist in der anhängenden Zeichnung schematisch wiedergegeben, die eine Zwei-Kathoden-Sputteranlage im Schnitt zeigt.

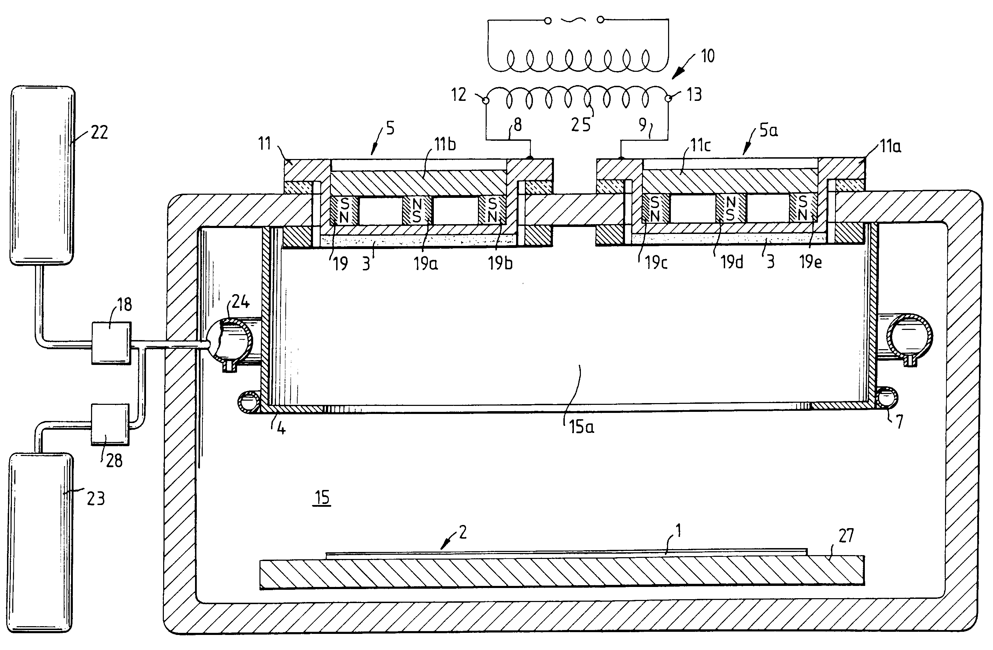

In der Zeichnung ist das Substrat 1 dargestellt, das mit einer dünnen Schicht 2 aus Zink-Oxyd versehen werden soll. Diesem Substrat 1 liegen Targets 3,3a gegenüber, die zu zerstäuben sind. Jedes Target 3,3a ist mit einem Kathodenkörper 11,11a verbunden, der ein Magnetjoch 11b,11c aufnimmt, das jeweils drei Magnete 19,19a,19b bzw. 19c,19d,19e aufweist.

Die auf die Targets 3,3a gerichteten Polaritäten der Pole der sechs Magnete wechseln sich ab, so daß jeweils die Südpole der beiden jeweils äußeren Magnete 19,19b bzw. 19c,19e mit dem Nordpol der jeweils innen liegenden Magnete 19a bzw. 19d etwa kreisbogenförmige Magnetfelder durch die Targets 3,3a bewirken. Diese Magnetfelder verdichten das Plasma vor den Targets, so daß es jeweils dort, wo die Magnetfelder das Maximum ihrer Kreisbögen aufweisen, seine größte Dichte hat. Die Ionen im Plasma werden durch elektrische Felder beschleunigt, die sich auf Grund der Wechselspannung aufbauen, die von der Stromquelle 10 abgegeben wird.

Diese Wechselstromquelle 10 weist zwei Anschlüsse 12,13 auf, die von den Enden einer sekundären Transformatorwicklung 25 gebildet sind und an den beiden Kathoden 5,5a angeschlossen sind. Die beiden Stromleiter 8,9 der sekundären Transformatorwicklung sind mit den beiden Targets 3,3a verbunden.

Das Target 3 ist außerdem mit einer gegen Erde geschalteten Spannungseffektivwerteerfassung verbunden, die wiederum mit einem Regelventil 18 in Verbindung steht, das den Zufluß des im Behälter 22 befindlichen Reaktivgases in die Verteilerleitung 24 der Vakuumkammer 15,15a kontrolliert.

Die Beschichtungskammer 15, 15a ist mit einem ring- oder rahmenförmigen Abschirmblech bzw. einer Blende 4 versehen. Der untere Rand der Blende 4 ist von einem Kühlrohr 7 umgriffen, das von einem Kühlmittel durchströmt ist und ein Überhitzen der Blende 4 verhindert.

Die Frequenz der Wechselstromquelle 10 ist während des Sputterprozesses so eingestellt, daß die Ionen dem Wechselfeld noch folgen können, was bei einer Frequenz von etwa 1 kHz - 100 kHz der Fall ist. Die abgegriffene Entladespannung wird mit Hilfe der Spannungseffektivwerteerfassung als Gleichspannung einem Regler zugeführt, der wiederum das Magnetventil 18 für die Zuführung des Reaktivgases ansteuert, und zwar derart, daß die gemessene Spannung einer bestimmten Reaktivgasmenge entspricht. Das Prozeßgas Argon befindet sich im Behälter 23 und kann über das Ventil 28 in die Verteilerleitung 24 einströmen.

## Patentansprüche

1. Verfahren zum Ablagern einer optisch transparenten und elektrisch leitenden Schicht (2), einer sogenannten low-e Schicht, auf einem Substrat (1) aus durchscheinendem Werkstoff mit Hilfe der Kathodenzerstäubung in einer Hochvakuumkammer (15,15a) unter Verwendung von Zink oder dotiertem Zink als Targetmaterial mit zwei in einer Ebene angeordneten, mit Wechselstrom betriebenen Sputterkathoden (5,5a) mit gleichen räumlichen Abständen zum Substrat (1) und mit einem Einlaß (24) für zwei Prozeßgase, einem inerten Gas und einem Reaktivgas, wobei der Reaktivgasanteil und die elektrische Leistungsdichte so bemessen sind, daß ein Zerstäuben der beiden Targets (3,3a) im metallischen Mode oder im Bereich zwischen metallischem und oxydischem Mode bewirkt wird.

2. Verfahren nach Anspruch 1, **dadurch gekennzeichnet**, daß die Prozeßgase Sauerstoff und Argon sind.

3. Verfahren nach den Ansprüchen 1 und 2, **dadurch gekennzeichnet**, daß der Einlaß der Prozeßgase in die Prozeßkammer (15,15a) mit Hilfe eines Verteilerrohrs (24) mit einer Vielzahl von Gasdüsen gleichmäßig auf die Zone zwischen beiden Targets (3,3a) und dem Substrat (1) verteilt erfolgt.
